# EUROPEAN PATENT SPECIFICATION

(11) **EP 1 276 238 B1**
(45) Date of publication and mention of the grant of the patent: **07.01.2004**
(21) Application number: 02022548.8
(22) Date of filing: 30.03.1995
(51) Int. Cl.: H03K 17/082

(54) **Gate drive circuit device for voltage-driven semiconductor element**
Gatetreiberschaltung zur Steuerung eines Halbleiterelements
Circuit d'attaque de grille pour élément semiconducteur commandé par tension

(30) Priority: 31.03.1994 JP 6183694
(43) Date of publication of application: 15.01.2003
(62) Divisional of application: 95104742.2
(73) Proprietor: FUJI ELECTRIC CO. LTD., Kawasaki 210 (JP)
(72) Inventor: Oyabe, Kazunori, c/o Fuji Electric Co., Ltd., Kawasaki 210-0856 (JP); Fujihira, Tatsuhiko, c/o Fuji Electric Co., Ltd., Kawasaki 210-0856 (JP); Yoshida, Kazuhiko, c/o Fuji Electric Co., Ltd., Kawasaki 210-0856 (JP); Yano, Yukio, c/o Fuji Electric Co., Ltd., Kawasaki 210-0856 (JP)
(74) Representative: Hoffmann, Eckart, Dipl.-Ing.

(56) References cited:
- EP-A- 0 319 047
- EP-A- 0 572 706
- FR-A- 2 692 415
- US-A- 4 992 683

## Description

The present invention relates to a gate drive circuit device for applying a gate drive signal to a gate of a voltage-driven semiconductor element and, more particularly, to a structure of a drive circuit device suitable for driving a voltage-driven semiconductor element connected to an inductive load.

### PRIOR ART

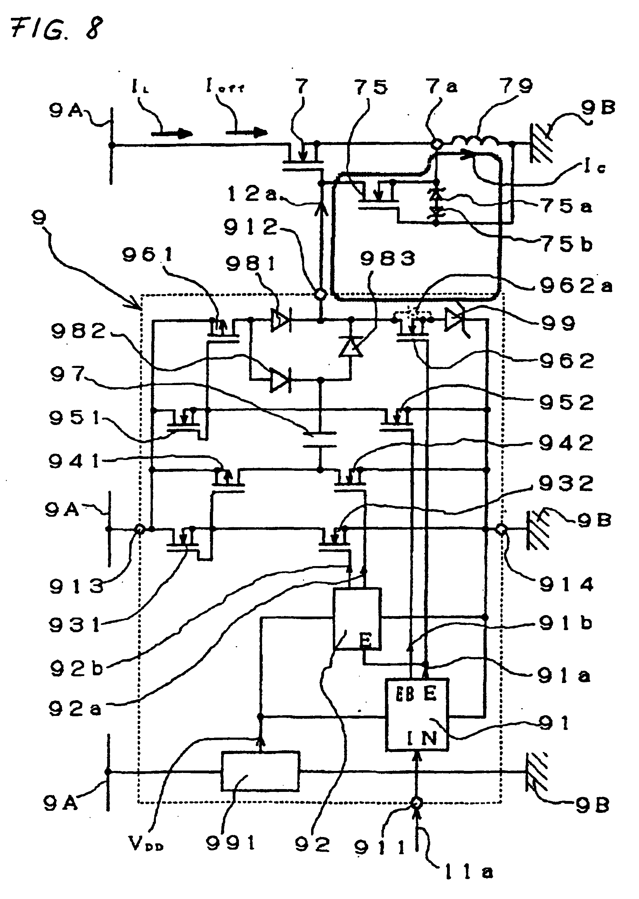

It is a long time ago that an electronic equipment using a power semiconductor element was first used as an electric apparatus for controlling an electric equipment having an inductive component such as an electromagnetic coil or an electric motor. A driver circuit for a FET having a ground referred load is known from European Patent Application no. EP 572 706. This circuit uses a charge pump and protective zener diodes. Recently, with the semiconductor technique being developed and improved, electronic equipments have been increasingly used in this field. An example of such an electronic equipment which performs the on/off driving of an electromagnetic coil using a voltage-driven semiconductor element as a power semiconductor element is shown in Fig. 8. In other words, Fig. 8 is a circuit diagram showing the power semiconductor element and associated components in a conventional gate drive circuit device for a voltage-driven semiconductor element.

In Fig. 8, reference numeral 9 denotes a gate drive circuit device which has a power supply terminal 913 for receiving the potential of a power supply line 9A, and a reference potential terminal 914 for receiving the potential of a ground line 9B as a reference potential. Thus, the gate drive circuit device 9 receives a supply voltage V_{cc} applied from a power source (not shown) between the power supply line 9A and the ground line 9B. The gate drive circuit device 9 also has an input terminal 911 for inputting a command signal 11a, and an output terminal 912 for outputting a gate drive signal 12a corresponding to the command signal 11a, to a gate of an n-channel enhancement MOSFET (hereinafter referred to as "nEMOS") 7 which is the main voltage-driven semiconductor element. The command signal 11a is a binary signal having any one of a high level (hereinafter referred to as "H") and a low level (hereinafter referred to as "L"). The nEMOS 7 is comprised of a semiconductor element which is turned on when the gate drive signal 12a is "H" and turned off when it is "L".

The gate drive circuit device 9 includes a logic circuit section 91, an oscillator circuit section 92, an n-channel depletion MOSFET (hereinafter referred to as "nDMOS") 931, an nEMOS 932, a p-channel enhancement MOSFET (hereinafter referred to as "pEMOS") 941, an nEMOS 952, an nDMOS 951, an nEMOS 952, a pEMOS 961, an nEMOS 962, a capacitor 97, diodes 981, 982 and 983, a voltage regulation diode 99, and a constant-voltage power supply section 991. The pEMOSs 941 and 961 are connected to the power supply line 9A at their sources.

The constant-voltage power supply section 991 is a circuit device which receives a supply voltage equal to the supply voltage V_{cc} to the gate drive circuit device 9, that is the voltage between the power supply line 9A and the ground line 9B, and supplies an auxiliary supply voltage V_{DD} which is stabilized to a constant voltage value. The logic circuit section 91 is a circuit device which receives the command signal 11a, outputs a signal 91a having the same level as that of the command signal 11a, from an enable (E) terminal thereof, and outputs a signal 91b having an inverse level of the command signal 11a, from a disenable (EB) terminal thereof. The oscillator circuit section 92 is a circuit device which receives the signal 91a, and outputs from one output terminal a signal 92a which alternates between "H" and "L" with a period shorter than the shortest duration of "H" or "L" of the command signal 11a, and from another terminal a signal 92b having the inverse level of the signal 92a,when the signal 91a is "L". The oscillator circuit section 92 does not output either of the signals 92a and 92b when the signal 91a is "H". The logic circuit section 91 and the oscillator circuit section 92 are supplied with the auxiliary supply voltage V_{DD} as a power supply therefor.

The nDMOSs 931 and 951 connected in the manner as shown in Fig. 8, as is well known, suppress currents flowing into the nDMOSs 931 and 951 to their saturation values, that is, a substantially constant current to prevent an excess current from flowing into circuit elements connected to the nDMOSs 931 and 951, when a large voltage is applied between their drain and source. The nDMOS 931 and 951 operate like a resistor element when a voltage applied between their drain and source is small.

When the command signal 11a is "L", the nEMOS 952 receives the signal 91b being "H" and is then turned on. As a result, the potential at a node between the source of the nDMOS 951 and the drain of the nEMOS 952 is lowered nearly to the potential of the ground line 9B, and the pEMOS 961 turns on. The nEMOS 962 receives the signal 91a being "L" and is turned off when the command signal 11 a is "L". As a result, when the command signal 11a is "L", the voltage of the power supply line 9A is outputted from the output terminal 912 through the pEMOS 961 and the diode 981.

The nEMOS 932 is turned on by receiving the signal 92b being "H". As a result, the potential at the node between the source of the nDMOS 931 and the drain of the nEMOS 932 is lowered nearly to the potential of the ground line 9B so that the pEMOS 941 turns on. The nEMOS 942 receives the signal 92a being "L" and is turned off when the signal 92b is "H". With the above operation, when the signal 92b is H", the potential of the power supply line 9A is applied to one terminal of the capacitor 97, which is connected to the pEMOS 941, through the pEMOS 941. When the signal 92b is "L", the nEMOS 932 is turned off. As a result, the potential at the node between the source of the nDMOS 931 and the drain of the nEMOS 932 is raised nearly to the potential of the power supply line 9A, thereby turning the pEMOS 941 off. The nEMOS 942 receives the signal 92a being "H" and is then turned on when the signal 92b is "L". With the above operation when the signal 92b is "L", the potential at the terminal of the capacitor 97, which is connected to the pEMOS 941, approaches to the potential of the ground line 9B. In other words, the terminal of the capacitor 97 connected to the pEMOS 941 is alternately brought to the potential close to that of the power supply line 9A and the potential close to that of the ground line 98 in accordance with a period of the signals 92a and 92b outputted from the oscillator circuit section 92.

In addition, with the command signal 11a being "L", the pEMOS 961 is turned on as described above and the other terminal of the capacitor 97, which is connected to the diode 982, is brought to the potential close to that of the power supply line 9A. Hence, in the case where the command signal 11 a is "L" and the signal 92b is "L", a voltage close to the supply voltage V_{cc} is applied across the capacitor 97 and the capacitor 97 is charged with that voltage. In the case where the command signal 11a is "L" and the signal 92b is "H", the capacitor 97 holds charges which have been charged therein, as a result of which the voltage across the capacitor 97 becomes a voltage corresponding to the amount of charges held by the capacitor 97. In this manner, charges are successively stored in the capacitor 97 as the signal 92a repeats being "H" and "L", whereby the voltage across the capacitor 97 rises up to a value close to the supply voltage V_{cc}. When the signal 92b is "H", the terminal of the capacitor 97, which is connected to the pEMOS 941, is supplied with the voltage of the power supply line 9A through the pEMOS 941 as described above, and the voltage at the terminal of the capacitor 97, which is connected to the diode 982, comes to the sum of the voltage close to the supply voltage V_{cc} and the voltage across the capacitor 97 which corresponds to the amount of charges held by the capacitor 97. The sum may be substantially twice as large as the voltage of the power supply line 9A. A voltage corresponding to the potential difference between the terminal of the capacitor 97, which is connected to the diode 982, and the ground line 9B is outputted from the output terminal 912 as a "H" value of the gate drive signal 12a during a period of the command signal 11a being "L".

The nEMOS 7 is turned on upon the gate drive signal 12a applied to its gate becoming "H". Since an electromagnetic coil 79, which is a load of the nEMOS 7, is connected between an output terminal 7a connected to the source of the nEMOS 7 and the ground line 9B, when the nEMOS 7 is on, the electromagnetic coil 79 is supplied with a voltage close to the supply voltage V_{cc} so that a current I_{L} flows through the nEMOS 7. Hence, the electromagnetic coil 79 assumes a predetermined excited state.

When the command signal 11a is changed to "H", the signal 91a outputted from the logic circuit section 91 is changed to "H", and the signal 91b is changed to "L". Since, upon inputting the signal 91a being "H", the oscillator circuit section 92 stops outputting the signals 92a and 92b, the operation of charging the capacitor 97 is stopped. Also, upon inputting the signal 91b being "L", the nEMOS 952 is turned off. As a result, since the potential at the node between the source of the nDMOS 951 and the drain of the nEMOS 952 rises nearly up to the potential close to that of the power supply line 9A, the pEMOS 961 with its gate connected to the node is turned off. At the same time, the nEMOS 962 is turned off upon inputting the signal 91a being "H", and then the potential of the output terminal 912 approaches to the potential of the ground line 9B. As a result, for the command signal 11a changed to "H", the potential of the output terminal 912 approaches to the potential of the ground line 9B. The potential of the output terminal 912 is outputted from the output terminal 912 as an "L" value of the gate drive signal 12a during a period of the command signal 11a being "H". The nEMOS 962 must have a parasitic diode 962a connected as shown in Fig. 8 due to the manufactured structure. For this reason, in this operating state, even though a slight voltage is superimposed on the ground line 9B, a resultant current flows toward the gate of the nEMOS 7 via the parasitic diode 962a. The voltage regulation diode 99 serves to prevent this phenomenon.

The nEMOS 7 is turned off immediately after the gate drive signal 12a is switched to "L" as described above, and then starts the operation of interrupting the current I_{L} flowing through the electromagnetic coil 79. However, since the electromagnetic coil 79, which exemplifies an electric equipment having an inductive component, has an inductance L, a counter electromotive force (= - L·dI_{L}/dt) is developed by the inductance L. The counter electromotive force is developed in a direction in which a circulating current I_{c} flows in a circuit including the electromagnetic coil 79 as shown in Fig. 8. The counter electromotive force causes a voltage to be applied between the gate of the nEMOS 7 and the source which is the other main electrode thereof. A voltage-driven power semiconductor element with a source provided as an output terminal generally has the following withstand voltage value between the gate and the source or the drain as one main electrode. That is, in the general nEMOS, a withstand voltage between the gate and drain thereof has a value exceeding a withstand voltage between the drain and source thereof, which is an element withstand value. On the other hand, a withstand voltage between the gate and source is ten volts or so at a maximum, which is appreciably smaller than the withstand voltage of the power semiconductor element. Hence, for the purpose of preventing the breakdown between the gate and source due to the counter electromotive force, the voltage applied between the gate and source of the nEMOS 7 at the time of generation of the counter electromotive force is required to be suppressed to a value below its withstand voltage. For that purpose, the nEMOS 75 is provided. The voltage regulation diodes 75a and 75b bidirectionally connected between the gate and source of the nEMOS 75 are elements for prevention of the breakdown between the gate and source of the nEMOS 75.

The nEMOS 75 has its drain connected to the gate of the nEMOS 7, its source connected to the source of the nEMOS 7, and its gate connected to the ground line 9B. Therefore, when the potential of the source of the nEMOS 7, that is, the potential of the output terminal 7a is made lower than that of the ground line 9B by generation of the counter electromotive force, the nEMOS 75 turns on, to thereby connect between the gate and source of the nEMOS 7. As a result, when the counter electromotive force is developed, no breakdown occurs between the gate and source of the nEMOS 7.

In the case where the nEMOS 75 is provided, a counter electromotive force, which is developed in the electromagnetic coil 79 in response to the command signal 11 a switched to "H", is applied to the voltage regulation diode 99 through the ground line 9B with a polarity directed from its cathode to its anode because the nEMOS 962 is on in this state. The counter electromotive force readily exceeds a breakdown voltage which is an operating voltage of the voltage regulation diode 99. Therefore, the circulating current I_{c} due to the counter electromotive force circulates through a path which passes through the electromagnetic coil 79, the ground line 9B, the voltage regulation diode 99 and the parasitic diode 962a of the nEMOS 962 in the stated order, and returns to the electromagnetic coil 79 via the nEMOS 75.

Under the state where the circulating current I_{c} flows into that path, a voltage drop is developed between the drain and source of the nEMOS 75 by existence of an electric resistance therebetween. That voltage drop is applied between the gate and source of the nEMOS 7, whereby the nEMOS 7 becomes again conductive and in a half-on state regardless of the gate drive signal 12a being "L". As a result, a sustained current I_{off} flows into the electromagnetic coil 79 from the power supply line 9A through the nEMOS 7 in a direction in which the current I_{L} flows. In the electromagnetic coil 79, electromagnetic energy W_{L} [= (1/2)LI²] is stored in a period where the command signal 11a is "L". The electromagnetic energy is consumed mainly in the nEMOS 7 as an electric power which is equal to a product of the sustained current I_{off} and a voltage developed between the drain and source of the nEMOS 7 in the half-on state. Consequently, the electromagnetic coil 79 release the electromagnetic energy W_{L} to the nEMOS 7 so as to be demagnetized. Thus, the electromagnetic coil 79 assumes a non-excited state.

The above-mentioned conventional gate drive circuit device 9 is constituted on the basis of an electronic circuit generally called the charging pump and the voltage regulation diode 99 added thereto. The charging pump adapted here is to output a voltage twice as large as the supply voltage V_{cc} from the terminal of the capacitor 97 which is connected to the diode 982. The gate drive circuit device thus constituted is capable of supplying the gate drive signal 12a of a level required by the power semiconductor element which is a main semiconductor element of the voltage-driven type even though the supply voltage V_{cc} is relatively low. In addition, the gate drive circuit device has such an advantage that the gate drive circuit device having the above functions and the power semiconductor element driven by the gate drive circuit device may be formed integrally on the same semiconductor substrate to be a so-called one-chip power semiconductor element which can be readily manufactured by common semiconductor element manufacturing techniques.

There have been known a lot of cases using an IGBT and the like rather than the MOSFET for the main semiconductor element of the voltage-driven type which is driven by the gate drive circuit device.

Moreover, there have been known a lot of cases using a p-channel power semiconductor element rather than the n-channel power semiconductor element for the main semiconductor element of the voltage-driven type which is driven by the gate drive circuit device.

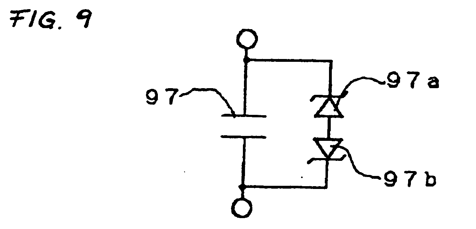

The above-mentioned conventional gate drive circuit device for the voltage-driven semiconductor element is capable of controlling an electric equipment, even though the equipment has an inductive component, by on/off-driving the voltage-driven power semiconductor element using that circuit device. However, it has been ascertained that such a conventional gate drive circuit device suffers from the following problems.
(1) In the case where a load of the power semiconductor element is an inductive electric equipment with an inductance L, sometimes the electromagnetic energy W_{L} stored in the electric equipment must be nullified at the turning off of the power semiconductor element. In such a situation, as was described in association with the conventional device, the electromagnetic energy is generally absorbed by a section of the power semiconductor element. In this case, a time required for nullifying the electromagnetic energy W_{L} stored in the electric equipment is satisfactorily shortened with an increase in the amount of energy which can be absorbed by the power semiconductor element per unit time. The electromagnetic energy absorbed by the power semiconductor element per unit time relates to a product of a drain-source voltage of the power semiconductor element and the current I_{off} flowing from its drain to its source at that time, and the absorption of the energy W_{L} in the prior art is performed by the power semiconductor element in the half-on state. The drain-source voltage of the power semiconductor element in the half-on state is several tens to 50 percent of the withstand voltage of the power semiconductor element, which is remarkably lower than its withstand voltage. Hence, the energy absorption capability of the power semiconductor element is not sufficiently utilized. Consequently, a long time is required for absorbing the electromagnetic energy W_{L} stored in the inductive electric equipment by the power semiconductor element at the turning off of the power semiconductor element. This has been limiting the high-speed operation of the electric equipment.
(2) In forming the gate drive circuit device 9 integrally with the semiconductor substrate, an insulating film formed on the semiconductor substrate by the general technique for manufacturing semiconductor elements is utilized as a dielectric for the capacitor 97. The withstand voltage of the insulating film of this type is as low as several ten volts at a maximum. Therefore, the capacitor 97 in this case, as shown in Fig. 9, is generally used to be connected in parallel with voltage regulation diodes 97a and 97b connected bidirectionally. Since a voltage close to the supply voltage V_{cc} is applied across the capacitor 97 as described above, when the supply voltage V_{cc} is varied to a higher value, a voltage exceeding the breakdown voltage of the voltage regulation diodes 97a and 97b is applied across the capacitor 97. In this case, a large reverse current flows into the voltage regulation diodes 97a and 97b in a path formed by the diode 982, the voltage regulation diodes 97a, 97b, the nEMOS 942 and the ground line 9B in the stated order, in accordance with the well-known operation of the voltage regulation diodes. That current is entirely useless for the gate drive circuit device 9. In particular, in a device used under a high supply voltage, or a device used under a wide range of supply voltages such as automobile electrical equipment, that useless current causes an increase in current consumption in the gate drive circuit device 9.

### SUMMARY OF THE INVENTION

The present invention has been made in view of the problems with the above-mentioned prior art, and an object of the invention is to provide a gate drive circuit device for a voltage-driven semiconductor element which is capable of suppressing an increase of a current consumption at a high supply voltage.

These objects are achieved with gate drive circuit device as claimed wherein specific embodiments of the invention are subject-matter of the dependent claims.

### OPERATION

With composition according to claim 1, applied to the gate of the voltage-driven semiconductor element of the auxiliary reference voltage circuit device is a voltage due to a built-in potential of the voltage regulation diode when the power voltage is equal to or under a breakdown voltage of the voltage regulation diode, and voltage equal to the difference between the supply voltage and the breakdown voltage of the voltage regulation diode when the supply voltage exceeds the sum of the voltage due to the built-in potential and the breakdown voltage of the voltage regulation diode. Accordingly, the voltage-driven semiconductor element of the auxiliary reference voltage circuit device is adapted to output an auxiliary reference voltage having a substantially constant difference from the supply voltage, which is the same as the breakdown voltage of the voltage regulation diode. Since the gate drive signal generator is supplied with its power from between the supply voltage and this auxiliary reference voltage, even though the supply voltage varies, a voltage supplied to the gate drive signal generator is regulated to be equal to or under the breakdown voltage of the voltage regulation diode.

As a result, a circuit element of the drive signal generator to which the supply voltage is applied, for example, a capacitor for the charging pump, can be supplied with a voltage restrained to the same level as the breakdown voltage of the voltage regulation diode at the highest.

With the structure according to claim 4 a voltage outputted from the constant-voltage circuit device is reduced by a voltage generated by the negative voltage generating circuit device. Therefore, a voltage generated from the constant-voltage circuit device under the supply voltage equal to or lower than the breakdown voltage of the voltage regulation diode has a value to which the voltage due to the built-in potential of the voltage regulation diode is reduced by a voltage generated by the negative voltage generating circuit device. Also, the supply voltage at which a gate voltage, a differential voltage between the supply voltage and the breakdown voltage of the voltage regulation diode, starts to be generated is a value to which the sum of the voltage due to the built-in potential and the breakdown voltage of the voltage regulation diode is reduced by a voltage generated by the negative voltage generating circuit device.

As a result, a range of the supply voltage, in which the difference between the supply voltage and the auxiliary reference voltage generated by the auxiliary reference voltage circuit device is substantially constant as being equal to the breakdown voltage of the voltage regulation diode, can be expanded toward the lower voltage range by an amount of voltage generated by the negative voltage generating circuit device.

Hereinafter, a description will be given in more detail of the embodiments of the present invention with reference to the accompanying drawings wherein like reference signs designate like parts.

### BRIEF DESCRIPTION OF THE DRAWINGS

- Fig. 1: is a block diagram of a gate drive circuit device showing its circuit with a power semiconductor element and associated components.
- Fig. 2: is a circuit diagram illustrating the gate drive circuit device shown in Fig. 1.
- Fig. 3: is a circuit diagram of a gate drive circuit device according an embodiment of the present invention, in which a power semiconductor element is shown with associated components.
- Fig. 4: is a circuit diagram showing the auxiliary reference voltage circuit device shown in Fig. 3.
- Fig. 5: is a graph showing a dependency of a gate voltage and auxiliary reference voltage on a supply voltage.
- Fig.6: is a circuit diagram showing an auxiliary reference voltage circuit device applied to another embodiment of a gate drive circuit device according to the present invention.
- Fig. 7: is a graph showing a dependency of a gate voltage and auxiliary reference voltage on a supply voltage.
- Fig. 8: is a circuit diagram showing a power semiconductor element and associated components in a conventional gate drive circuit device for a voltage-driven semiconductor element.
- Fig. 9: is a circuit diagram showing a capacitor used in a charging pump.

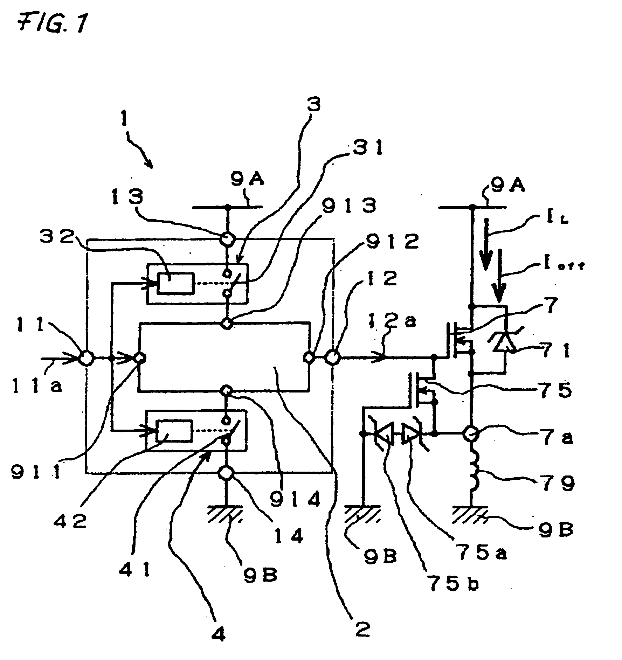

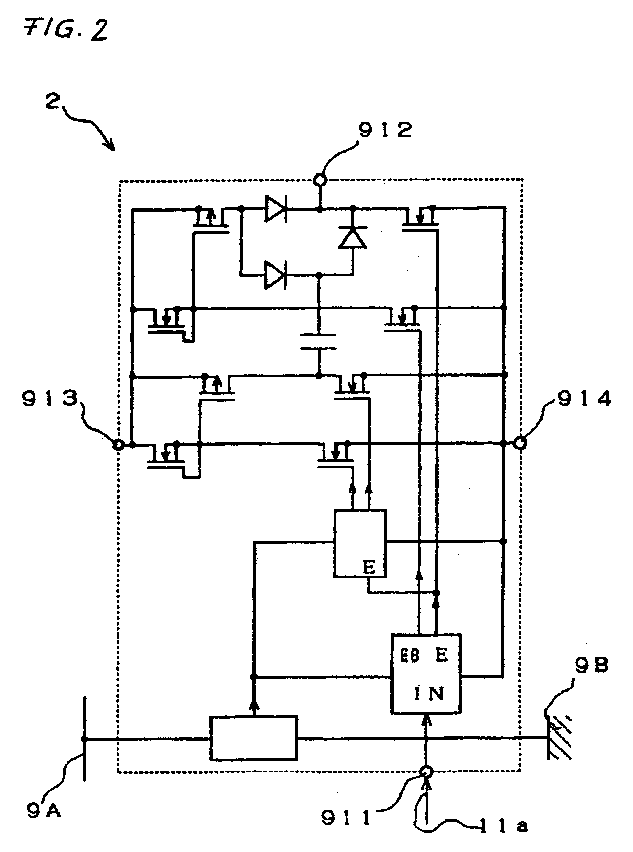

Fig. 1 is a block diagram of one embodiment of a gate drive circuit device for a voltage-driven semiconductor element corresponding to the present invention showing its circuit with a power semiconductor element and associated ones. Fig. 2 is a circuit diagram of the gate drive signal generator shown in Fig. 1. In Figs. 1 and 2, the same elements as those of the conventional gate drive circuit device for the voltage-driven semiconductor element are designated with the same reference numerals, and their description will be omitted. In Fig. 2, with respect to the reference numerals shown in Fig. 8, only the representative ones are indicated.

In Figs. 1 and 2, reference numeral 1 denotes a gate drive circuit device for a voltage-driven semiconductor element, for which a circuit composed with the voltage regulation diode 99 removed from the conventional gate drive circuit device 9 shown in Fig. 8 is used as a gate drive signal generator 2 and a power supply side switching means 3 and a reference potential side switching means 4 are added thereto. The power supply side switching means 3 includes a switching device 31 for switching an electric circuit and an operating section 32 for allowing the switching device 31 to perform the switching operation. The switching device 31 is connected between a power supply terminal 13 of the gate drive circuit device 1 and a power supply terminal 913 of the gate drive signal generator 2. The operating section 32 receives a command signal 11a and closes the switching device 31 when the command signal 11a is an on-command, while it opens the switching device 31 when it is an off-command.

The reference potential side switching means 4 includes a switching device 41 for switching the electric circuit and an operating section 42 for allowing the switching device 41 to perform the switching operation. The switching device 41 is connected between a reference potential terminal 14 of the gate drive circuit device 1 and a reference potential terminal 914 of the gate drive signal generator 2. The operating section 42 receives the command signal 11a, and closes the switching device 41 when the command signal 11a is the on-command, but opens the switching device 41 when it is the off-command.

An nEMOS 7, whose gate is connected to an output terminal 912 of the gate drive signal generator 2 through an output terminal 12 of the gate drive circuit device 1 for the gate drive signal 12a, is connected in parallel with a voltage regulation diode 71 as a voltage stabilizing means between the drain and source thereof, as shown in Fig. 1. The voltage regulation diode 71 has a breakdown voltage, which is an operating voltage thereof, set to a value slightly lower than the withstand voltage of the nEMOS 7. Reference numeral 11 denotes an input terminal of the gate drive circuit device 1 to which the command signal 11a is inputted.

In the embodiment thus constituted as shown in Figs. 1 and 2, by turning the nEMOS 7 off with the gate drive signal 12a switched from "H" to "L", the electromagnetic coil 79 generates a counter electromotive force. This is completely identical with the case of the conventional gate drive circuit device 9.

In the gate drive circuit device 1 in accordance with the present invention, simultaneously with the nEMOS 7 being turned off by inputting the command signal 11a which is the off-command, the switching device 31 and the switching device 41 are opened. Therefore, the voltage due to the counter electromotive force is applied only to a parallel circuit consisting of the nEMOS 7 and the voltage regulation diode 71. When the counter electromotive force is applied to that parallel circuit, the voltage regulation diode 71, whose breakdown voltage is set to the above-mentioned value, operates in its breakdown region with the counter electromotive force exceeding that breakdown voltage. As a result, a current I_{off} due to release of an electromotive energy W_{L} (which has been stored while the nEMOS 7 was on) stored in the electromagnetic coil 79 flows into the voltage regulation diode 71. In other words, most of the electromagnetic energy W_{L} is absorbed with the voltage regulation diode 71. The degree of the electromagnetic energy W_{L} absorption with the voltage regulation diode 71 is remarkably increased in comparison with a case where the electromagnetic energy is absorbed with the nEMOS 7 in a half-on state as in the conventional gate drive circuit device 9, because the breakdown voltage of the voltage regulation diode 71 is set to a value slightly lower than the withstand voltage of the nEMOS 7. As a result, a time required for absorbing the electromagnetic energy W_{L} with the voltage stabilizing means can be reduced.

### Embodiment 1:

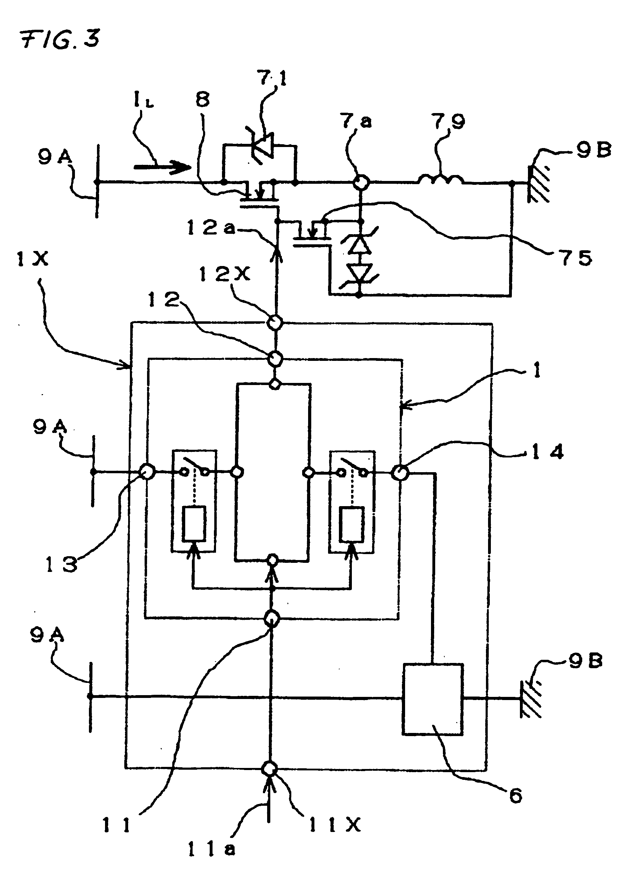

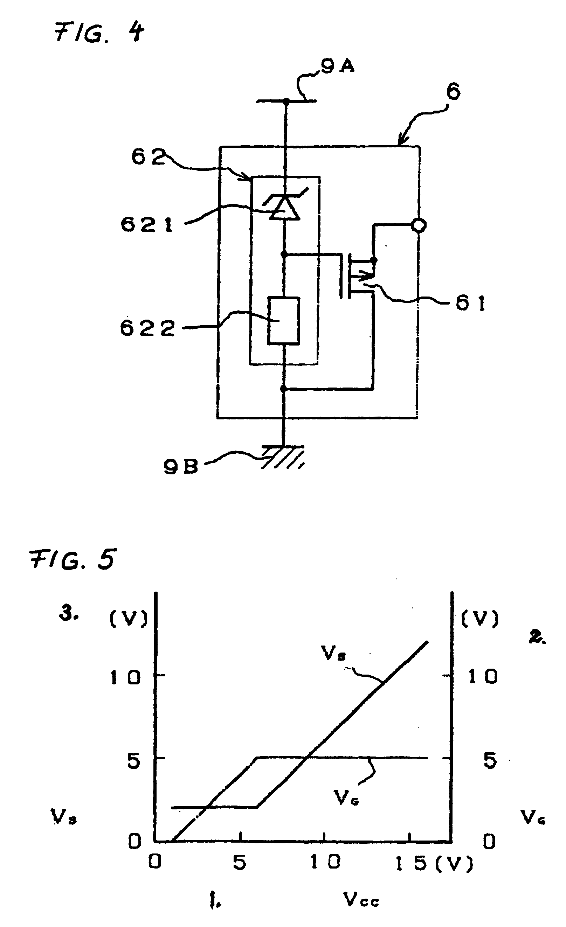

Fig. 3 is a circuit diagram of an embodiment of a gate drive circuit device for a voltage-driven semiconductor element corresponding to the present invention, in which a power semiconductor element is shown with associated components. Fig. 4 is a circuit diagram showing the auxiliary reference voltage circuit device shown in Fig. 3. In Figs. 3 and 4, the same elements as those shown in Figs. 1 and 2 and those in Fig. 8 are designated with the same reference numerals, and their description will be omitted. In Fig. 3, with respect to the reference numerals shown in Figs. 1, 2 and 8, only the representative ones are indicated.

In Figs. 3 and 4, reference numeral 1X denotes a gate drive circuit device for which an auxiliary reference voltage circuit device 6 are added to the gate drive circuit device 1 shown in Figs. 1 and 2 according to one embodiment of the present invention. As shown in Fig. 4, the auxiliary reference voltage circuit device 6 includes a pEMOS 61 and a constant-voltage circuit device 62 for outputting a gate voltage of a substantially constant value to the gate of the pEMOS 61. The constant-voltage circuit device 62, to which the supply voltage V_{cc} is supplied, has a voltage regulation diode 621 disposed at the power source line 9A side and a resistance element 622 disposed at the ground line 9B side, both being connected in series with a node between them being connected to the gate of the pEMOS 61. The pEMOS 61 has its source connected to the reference potential terminal 14 of the gate drive circuit device 1 and its drain connected to the ground line 9B. Reference numeral 11X denotes an input terminal for inputting the command signal 11a to the gate drive circuit device 1X.

With the above composition of the embodiment shown in Figs. 3 and 4, as was described in the section of the operation, the gate voltage V_{G} applied to the gate of the pEMOS 61 varies with a variation in the supply voltage V_{cc} as shown in Fig. 5 with a change in its variation at the breakdown voltage of the voltage regulation diode 621. The source voltage of the pEMOS 61 driven by its gate voltage V_{G} is provided as an auxiliary reference voltage Vₛ. Hence, the auxiliary reference voltage Vₛ is substantially equal to the voltage difference between the supply voltage V_{cc} and the gate voltage V_{G}. This makes a voltage applied between the power supply terminal 13 and ground potential terminal 14 of the gate drive circuit device 1 substantially equal to the gate voltage V_{G}, which is the difference between the supply voltage V_{cc} and the auxiliary reference voltage Vₛ that can be limited to the breakdown voltage of the voltage regulation diode 621.

### Embodiment 2:

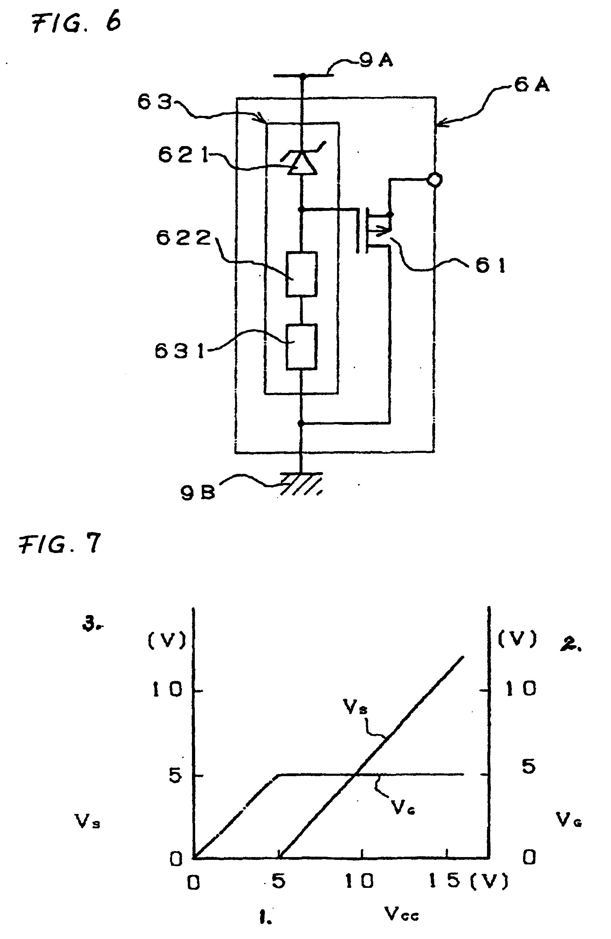

Fig. 6 is a circuit diagram showing an auxiliary reference voltage circuit device applied to still another embodiment of a gate drive circuit device for a voltage-driven semiconductor element corresponding to claims 1 and 2 of the present invention. In Fig. 6, the same elements as those shown in Fig. 4 illustrating the auxiliary reference voltage circuit device applied to still another embodiment of the gate drive circuit device for the voltage-driven semiconductor element corresponding to claims 1 to 3 of the present invention are designated with the same reference numerals, and their description will be omitted.

In Fig. 6, reference numeral 6A denotes a circuit device using the constant-voltage circuit device 63 instead of the constant-voltage circuit device 62 in the auxiliary reference voltage circuit device 6 as shown in Fig. 4 according to still another embodiment of the present invention. The constant-voltage circuit device 63 differs from the constant-voltage circuit device 62 in providing a negative voltage generator 631 that is connected between the resistance element 622 and the ground line 9B.

With the above composition of the embodiment shown in Fig. 6, as was described in the section of the operation, the gate voltage V_{G} applied to the gate of the pEMOS 61 varies with a variation in the supply voltage V_{cc} as shown in Fig. 7 with a change in its variation at a voltage equivalent to the difference between the breakdown voltage of the voltage regulation diode 621 and the voltage across the negative voltage generator 631. In Fig. 7, it can be observed that a range of the supply voltage V_{cc}, in which the difference between the supply voltage V_{cc} and the auxiliary reference voltage Vₛ is held at a constant value corresponding to the breakdown voltage of the voltage regulation diode 621 is expanded toward lower voltages by an amount of voltage generated by the negative voltage generator 631.

In the above description of the embodiments 1 and 2, the gate drive circuit device 1X has been described as including the auxiliary reference voltage circuit devices 6 or 6A added to the gate drive circuit device 1. However, it is not limited to this composition and modification is possible so that, for example, the gate drive circuit device 1 may be any of the gate drive circuit devices 1A to 1D.

## Claims

1. A gate drive circuit device for a voltage-driven semiconductor element for applying a gate drive signal to a gate of a main voltage-driven semiconductor element (8), comprising:
said main semiconductor element having one main electrode thereof connected to a power supply (9A) or a reference potential point (9B) and the other main electrode thereof connected to a load (79),
an auxiliary reference voltage circuit device (6; 6A) connected between the power supply and the reference potential point for outputting an auxiliary reference voltage which has an intermediate value between a supply voltage and a voltage of the reference potential and varies in accordance with a variation of the supply voltage so as to maintain the difference between that voltage and the supply voltage substantially constant, and
a gate drive signal generator to which a command signal commanding the on/off operation of said main semiconductor element (8) is inputted for generating a gate drive signal corresponding to the command signal,
wherein said gate drive signal generator uses said auxiliary reference voltage as a reference voltage.

2. The device of claim 1, wherein said auxiliary reference voltage circuit device (6) has a voltage-driven semiconductor element (61) and a constant-voltage circuit device (62; 63) for outputting a gate voltage to a gate of said semiconductor element, the difference between said gate voltage and the supply voltage being maintained substantially constant, said semiconductor element has one main electrode thereof connected to the reference potential side and the other main electrode thereof from which the auxiliary reference voltage is outputted, and said constant-voltage circuit device is connected between the power supply (9A) and the reference potential point (9B).

3. The device of claim 2, wherein said constant-voltage circuit device (62) includes a voltage regulation diode (621) and a resistance element (622), said voltage regulation diode is arranged at the power supply side and said resistance element is arranged at the reference potential side so that said voltage regulation diode and said resistance element are connected in series to each other, and said gate voltage is outputted from a node between said voltage regulation diode and said resistance element.

4. The device of claim 1, wherein said constant-voltage circuit device (63) includes a voltage regulation diode (621), a resistance element (622) and a negative voltage generating circuit device (631), said voltage regulation diode is arranged at the power supply side and a series circuit consisting of said resistance element and said negative voltage generating circuit device is arranged at the reference potential side so that said voltage regulation diode and said series circuit are connected in series to each other, and said gate voltage is outputted from a node between said voltage regulation diode and said series circuit consisting of said resistance element and said negative voltage generating circuit device.

5. The device of any one of the preceding claims, wherein a voltage stabilizing means (71) for protecting said main semiconductor element (7; 8) from an over-voltage is connected to said main semiconductor element.

6. The device of any one of the preceding claims, further comprising additional switching means (7C) including a voltage-driven semiconductor element (75) and control means (72C, 91) for switching said semiconductor element (75) on in response to an off-command and off in response to an on-command, said semiconductor element (75) having one main electrode connected to the gate of said main semiconductor element (7), another main electrode connected to the load side main electrode of the main semiconductor element (7) and the gate connected to said control means (72C, 91).

## Patentansprüche

1. Gate-Ansteuerschaltungsvorrichtung für ein spannungsgesteuertes Halbleiterelement zum Anlegen eines Gate-Ansteuersignals an ein Gate eines spannungsgesteuerten Haupthalbleiterelements (8), umfassend:
das Haupthalbleiterelement, dessen eine Hauptelektrode an eine Stromversorgung (9A) oder einen Bezugspotentialpunkt (9B) und dessen andere Hauptelektrode an eine Last (79) angeschlossen ist,
eine Zusatzbezugsspannungs-Schaltungsvorrichtung (6; 6A), die zwischen die Stromversorgung und den Bezugspotentialpunkt geschaltet ist zur Ausgabe einer Zusatzbezugsspannung, die einen Zwischenwert zwischen der Spannung der Stromversorgung und der Spannung des Bezugspotentials hat und sich in Übereinstimmung mit einer Änderung der Spannung der Stromversorgung ändert, um die Differenz zwischen der Zusatzbezugsspannung und der Spannung der Stromversorgung im wesentlichen konstant zu halten, und
einen Gate-Ansteuersignalgenerator, dem ein den EIN/AUS-Betrieb des Haupthalbleiterelements (8) befehlendes Befehlssignal eingegeben wird zur Erzeugung eines Gate-Ansteuersignals entsprechend dem Befehlssignal,
wobei der Gate-Ansteuersignalgenerator die Zusatzbezugsspannung als Bezugsspannung verwendet.

2. Vorrichtung nach Anspruch 1, bei der die Zusatzbezugsspannungs-Schaltungsvorrichtung (6) ein spannungsgesteuertes Halbleiterelement (61) und eine Konstantspannungs-Schaltungsvorrichtung (62; 63) zur Ausgabe einer Gate-Spannung an ein Gate des Halbleiterelements aufweist, wobei die Differenz zwischen der Gate-Spannung und der Speisespannung im wesentlichen konstant gehalten wird, und wobei die eine Hauptelektrode des Halbleiterelements mit der Bezugspotentialseite verbunden ist, und von seiner anderen Hauptelektrode die Zusatzbezugsspannung ausgegeben wird, und wobei die Konstantspannungs-Schaltungsvorrichtung zwischen die Stromversorgung (9A) und den Bezugspotentialpunkt (9B) geschaltet ist.

3. Vorrichtung nach Anspruch 2, bei der die Konstantspannungs-Schaltungsvorrichtung (62) eine Spannungsregeldiode (621) und ein Widerstandselement (622) umfaßt, wobei die Spannungsregeldiode an der Stromversorgungsseite und das Widerstandselement an der Bezugspotentialseite angeordnet ist, so daß die Spannungsregeldiode und das Widerstandselement zueinander in Reihe geschaltet sind, und wobei die Gate-Spannung von einem Knoten zwischen der Spannungsregeldiode und dem Widerstandselement ausgegeben wird.

4. Vorrichtung nach Anspruch 1, bei der die Konstantspannungs-Schaltungsvorrichtung (63) eine Spannungsregeldiode (621), ein Widerstandselement (622) und eine eine negative Spannung erzeugende Schaltungsvorrichtung (631) umfaßt, wobei die Spannungsregeldiode an der Stromversorgungsseite angeordnet ist und eine Reihenschaltung aus dem Widerstandselement und der eine negative Spannung erzeugenden Schaltungsvorrichtung an der Bezugspotentialseite angeordnet ist, so daß die Spannungsregeldiode und die Reihenschaltung miteinander in Reihe geschaltet sind, und die Gate-Spannung von einem Knoten zwischen der Spannungsregeldiode und der aus dem Widerstandselement und der eine negative Spannung erzeugenden Schaltungsvorrichtung bestehenden Reihenschaltung ausgegeben wird.

5. Vorrichtung nach einem der vorhergehenden Ansprüche, bei der eine Spannungsstabilisiereinrichtung (71) zum Schützen des Haupthalbleiterelements (7; 8) vor Überspannung mit dem Haupthalbleiterelement verbunden ist.

6. Vorrichtung nach einem der vorhergehenden Ansprüche, ferner mit einer zusätzlichen Schalteinrichtung (7C), die ein spannungsgesteuertes Halbleiterelement (75) und eine Steuereinrichtung (72C, 91) zum Einschalten des Halbleiterelements (75) in Abhängigkeit von einem AUS-Befehl und zum Abschalten in Abhängigkeit von einem EIN-Befehl umfaßt, wobei das Halbleiterelement (75) eine Hauptelektrode hat, die mit dem Gate des Haupthalbleiterelements (7) verbunden ist, eine weitere Hauptelektrode, die mit der lastseitigen Hauptelektrode des Haupthalbleiterelements (7) verbunden ist und ein Gate, welches mit der Steuereinrichtung (72C, 91) verbunden ist.

## Revendications

1. Dispositif d'attaque de grille pour un élément à semi-conducteur commandé par tension pour appliquer un signal d'attaque de grille à une grille d'un élément (8) principal à semi-conducteur commandé par tension comprenant :
- l'élément principal à semi-conducteur a son électrode principale reliée à une alimentation (9A) en courant ou à un point (9B) de potentiel de référence et son autre électrode principale reliée à une charge (79),
- un dispositif (6, 6A) de circuit de tension de référence auxiliaire monté entre l'alimentation en courant et le point de potentiel de référence en vue d'émettre en sortie une tension de référence auxiliaire qui a une valeur intermédiaire entre une tension d'alimentation et une tension du potentiel de référence et varie en fonction d'une variation de la tension de l'alimentation de manière à maintenir sensiblement constante la différence entre cette tension et la tension d'alimentation, et
- un générateur de signal d'attaque de grille, auquel est envoyé un signal de commande commandant le fonctionnement état passant/état non pasant de l'élément (8) principal à semi-conducteur pour engendrer un signal d'attaque de grille correspondant au signal de commande,
le générateur de signal d'attaque de grille utilisant la tension de référence auxiliaire comme tension de référence.

2. Dispositif suivant la revendication 1, dans lequel le dispositif 6 de circuit de tension de référence auxiliaire a un élément (61) à semi-conducteur commandé par tension et un dispositif (62, 63) de circuit à tension constante pour envoyer une tension de grille à une grille de l'élément à semi-conducteur, la différence entre la tension de grille et la tension d'alimentation étant maintenue sensiblement constante, l'élément à semi-conducteur ayant l'une de ses électrodes principales reliée au côté du potentiel de référence et son autre électrode de laquelle sort la tension de référence auxiliaire et le dispositif de circuit à tension constante est montée entre la source (9A) d'alimentation et le point (9B) de potentiel de référence.

3. Dispositif suivant la revendication 2 dans lequel le dispositif (62) de circuit à tension constante, comprend une diode (621) de régulation de la tension et un élément (622) résistant, la diode de régulation de la tension étant montée du côté de l'alimentation en courant et l'élément résistant étant monté du côté du potentiel de référence, de sorte que la diode de régulation de la tension et l'élément résistant sont montés en série l'un avec l'autre et la tension de grille sort d'un noeud compris entre la diode de régulation de la tension et l'élément résistant.

4. Dispositif suivant la revendication 1, dans lequel le dispositif (63) de circuit à tension constante comprend une diode (621) de régulation de la tension, un élément (622) résistant et un dispositif (631) de circuit engendrant une tension négative, la diode de régulation de la tension étant montée du côté de l'alimentation en courant et un circuit série consistant en l'élément résistant et en le dispositif de circuit engendrant une tension négative est montée du côté du potentiel de référence de sorte que la diode de régulation de la tension et le circuit série sont montés en série l'un avec l'autre et la tension de grille sort d'un noeud compris entre la diode de régulation de la tension et le circuit série consistant en l'élément résistant et en le dispositif de circuit engendrant une tension négative.

5. Dispositif suivant l'une quelconque des revendications précédentes, dans lequel des moyens (71) de stabilisation de la tension destinés à protéger l'élément (7, 8) principal à semi-conducteur d'une surtension sont reliés à l'élément principal à semi-conducteur.

6. Dispositif suivant l'une quelconque des revendications précédentes, comprenant en outre des moyens (7C) supplémentaires de commutation comprenant un élément (75) à semi-conducteur commandé par tension et des moyens (72C, 91) de commande, pour mettre l'élément (75) à semi-conducteur à l'état passant en réponse à une commande d'arrêt et pour le mettre à l'état non passant en réponse à une commande de marche, l'élément (75) à semi-conducteur ayant une électrode principale reliée à la grille de l'élément (7) principal à semi-conducteur, une autre électrode principale reliée à l'électrode principale du côté de la charge de l'élément (7) principal à semi- conducteur et la grille reliée aux moyens (72C, 91) de commande.
